# EUROPEAN PATENT APPLICATION

(11) **EP 4 355 044 A1**
(43) Date of publication of application: **17.04.2024**
(21) Application number: 22848412.7
(22) Date of filing: 21.07.2022
(51) Int. Cl.: H05K 7/20

(54) **LIQUID COOLING PLATE, LIQUID COOLING SYSTEM AND ELECTRONIC DEVICE**

(30) Priority: 27.07.2021 CN 202110851310
(71) Applicant: Huawei Technologies Co., Ltd., Longgang Shenzhen, Guangdong 518129 (CN)
(72) Inventor: WANG, Jianliang, Shenzhen, Guangdong 518129 (CN); KUSHNER, Dzmitry, Shenzhen, Guangdong 518129 (CN); LI, Jiyang, Shenzhen, Guangdong 518129 (CN); XIE, Shuqin, Shenzhen, Guangdong 518129 (CN); ZHOU, Along, Shenzhen, Guangdong 518129 (CN); SHI, Jian, Shenzhen, Guangdong 518129 (CN); XU, Shoubiao, Shenzhen, Guangdong 518129 (CN)
(74) Representative: Huawei European IPR
(86) International application number: PCT/CN2022/107179
(87) International publication number: WO 2023/005807

(57) **Abstract**

This application provides a liquid cooling plate, a liquid cooling system, and an electronic device. The liquid cooling plate includes a housing, a support structure, and a coolant. The housing includes a top wall and a bottom wall, the top wall and the bottom wall are covered to form an accommodation cavity, and the accommodation cavity includes a first region and a second region. The support structure is disposed in the first region and is located between the top wall and the bottom wall. The coolant flows in the accommodation cavity to dissipate heat from a heat generating device, the coolant can expand in volume when being heated and shrink in volume when being cooled, and the second region can deform to absorb a volume variation of the coolant. According to technical solutions of this application, under the development trend of miniaturization, and lightness and thinning of the liquid cooling plate, a volume change of the liquid coolant in the liquid cooling plate can be absorbed, pressure inside the liquid cooling system can be reduced, and impact of the volume change of the coolant on working reliability of the liquid cooling plate, the liquid cooling system, and peripheral components is reduced.

## Description

This application claims priority to Chinese Patent Application No. 202110851310.4, filed with the China National Intellectual Property Administration on July 27, 2021 and entitled "LIQUID COOLING PLATE, LIQUID COOLING SYSTEM, AND ELECTRONIC DEVICE", which is incorporated herein by reference in its entirety.

### TECHNICAL FIELD

This application relates to the field of heat dissipation technologies, and in particular, to a liquid cooling plate, a liquid cooling system, and an electronic device.

### BACKGROUND

With the rapid development of electronic devices such as a smartphone and a notebook computer, a technology of using a liquid cooling plate as a heat dissipation apparatus in the electronic device is increasingly mature. As the electronic device develops towards miniaturization, reducing a volume of the liquid cooling plate to adapt to a development trend of miniaturization of the electronic device is gradually put on the agenda. In an existing liquid cooling plate, as the liquid cooling plate becomes lighter and thinner, mechanical strength of the liquid cooling plate gradually becomes weaker, and working reliability of the liquid cooling plate is significantly affected. Under the development trend of miniaturization, and lightness and thinning of the liquid cooling plate, how to reduce impact of volume expansion of a liquid coolant in the liquid cooling plate on the working reliability of the liquid cooling plate is a subject of continuous exploration in the industry.

### SUMMARY

Embodiments of this application provide a liquid cooling plate, a liquid cooling system, and an electronic device. Under the development trend of miniaturization, and lightness and thinning of the liquid cooling plate, a volume change of a liquid coolant in the liquid cooling plate can be absorbed, pressure inside the liquid cooling system can be reduced, and impact of the volume change of the coolant on working reliability of the liquid cooling plate, the liquid cooling system, and peripheral components is reduced.

Currently, most terminal and quasi-terminal products, such as a notebook computer and a mobile phone, adopt natural heat dissipation to resolve a heat dissipation problem. As the terminal and quasi-terminal products develop towards light, thin, small, and easy to carry, liquid cooling can improve a heat dissipation capability of the terminal products. Due to a small size of the terminal product, a volume of a liquid cooling plate needs to be reduced accordingly. Therefore, how to realize lightness and high strength of the liquid cooling plate has gradually become a key technology. At present, an ultra-thin cooling plate is weak in mechanical strength, and problems of cooling plate bulging and coolant leakage are easy to occur due to volume expansion when a temperature of the liquid coolant is high. This may interfere with operation of the device and cause a fault in a severe case.

However, technical solutions provided in this application can effectively resolve the foregoing problems, and details are further described below.

A first aspect of this application provides a liquid cooling plate. The liquid cooling plate includes:
a housing, where the housing includes a top wall and a bottom wall, the top wall and the bottom wall are covered to form an accommodation cavity, and the accommodation cavity includes a first region and a second region;
a support structure, where the support structure is disposed in the first region and is connected between the top wall and the bottom wall; and
a coolant, where the coolant flows in the accommodation cavity to dissipate heat from a heat generating device, the coolant can expand in volume when being heated and shrink in volume when being cooled, and the second region can deform to absorb a volume variation of the coolant.

It may be understood that, the coolant undergoes thermal expansion and contraction when the temperature changes, in other words, the coolant can expand in volume when being heated and shrink in volume when being cooled. If there is no space inside the liquid cooling plate for deformation of the coolant, the coolant is almost incompressible. This may cause a large stress to damage the liquid cooling plate, or the liquid cooling plate may expand at a weakest position, which may interfere with a surrounding component at the weakest position of the structure, and may cause structural damage. Therefore, when the coolant flows inside the liquid cooling plate, the volume change of the coolant caused by a temperature change should be considered when the structure of the liquid cooling plate is set, so that the overall liquid cooling plate has a good mechanical strength, and working reliability of the liquid cooling plate, a liquid cooling system, and peripheral components is improved.

The top wall of the housing and the bottom wall of the housing form an inner wall of the accommodation cavity. Specifically, the top wall of the housing is a top wall of the accommodation cavity, and the bottom wall of the housing is a bottom wall of the accommodation cavity. The support structure is connected between the top wall and the bottom wall, in other words, the support structure is supported between the top wall and the bottom wall, and can provide strong support for the mechanical strength of the liquid cooling plate. For example, a cross-sectional form of the support structure may include one or a combination of a plurality of shapes such as a rectangle, a circle, and a diamond. The shape of the support structure may be flexibly adjusted based on an actual situation, and this is not strictly limited. The support structure may be made through etching, stamping, or the like. The support structure may be disposed on a top cover plate and connected to a bottom cover plate through brazing, laser welding, or the like. Alternatively, the support structure may alternatively be disposed on the bottom cover plate and connected to the top cover plate through brazing, laser welding, or the like.

In a technical solution of this application, the housing can be divided into the first region and the second region by adjusting a position of the support structure. Specifically, the support structure is disposed in only the first region, and the support structure may not be disposed in the second region.

Therefore, the second region can be made into a deformable region with soft strength by providing no support structure, thereby effectively reducing local bending stiffness of the second region, so that the second region has a greater deformation capability than the first region, and absorbs volume and pressure changes of the liquid coolant in the accommodation cavity through moderate deformation. In addition, a support column in the first region is supported between the top wall and the bottom wall, so that the first region is made into a hard and less deformable region, thereby effectively improving local bending stiffness of the first region, so that the first region has a smaller deformation capability than the second region. The first region can provide better mechanical strength for the overall liquid cooling plate and ensure the working reliability of the liquid cooling plate during operation.

Based on the foregoing description, it should be understood that the accommodation cavity includes the first region and the second region, and the second region can deform to absorb the volume variation of the coolant. It should be understood that the volume change of the coolant includes volume expansion caused by a temperature increase of the coolant due to heat absorption, and volume shrinkage caused by a temperature decrease of the coolant due to cooling. Based on this, deformation of the second region includes both volume expansion caused by adapting to volume expansion of the coolant and volume shrinkage caused by adapting to volume shrinkage of the coolant.

The accommodation cavity can be divided into two regions: the first region and the second region based on different functions of the two regions. A structure for ensuring mechanical strength of the overall liquid cooling plate may be disposed in the first region, and a structure capable of providing a deformation space adapted to the volume variation of the coolant due to thermal expansion and contraction may be disposed in the second region.

In this arrangement, the liquid cooling plate has high strength while maintaining a small volume. This helps reduce a thickness of the liquid cooling plate to a maximum extent under a development trend of miniaturization of an electronic device, and effectively implement lightness and thinning of the liquid cooling plate. In addition, when the coolant flows in the liquid cooling plate, the volume variation of the coolant caused by the temperature change can be fully considered, so that the second region can absorb the volume variation of the coolant due to a moderate deformation space. The moderate deformation space is provided for the volume change of the coolant. Possibilities of problems in the conventional technology such as cooling plate bulging and coolant leakage caused by volume expansion of the liquid coolant due to a high temperature are minimized, and the working reliability of the liquid cooling plate is good.

That is, the liquid cooling plate in this embodiment of this application has advantages of being light and thin and absorbing thermal expansion and contraction of the coolant through proper deformation on the basis of high strength. Therefore, under the development trend of miniaturization of the liquid cooling plate, the thickness of the liquid cooling plate may be further reduced to realize thinness of the liquid cooling plate.

It should be noted that division of the first region and the second region indicates that the second region is a part specially designed to be easy to deform, and the first region is a part specially designed to be difficult to deform. It does not mean that the first region does not deform, and it does not mean that the second region does not play a role of ensuring the overall mechanical strength of the liquid cooling plate. That is, in the housing, the first region and the second region have different deformation capabilities and different degrees of mechanical strength that can be provided for the overall housing.

In addition, a position relationship between the first region and the second region may be flexibly adjusted based on an actual arrangement of electronic components inside the electronic device. The second region should be as close as possible to a region without an object, in other words, there should be as few structures or devices around the second region as possible. Therefore, a specific expansion space for the second region to expand can be reserved around the second region, so as to ensure that deformation of the second region does not squeeze or damage a surrounding structure. An area ratio of the second region to the first region may alternatively be adjusted based on an actual situation, provided that the second region can absorb shrinkage and expansion of the coolant. This is not strictly limited.

In the technical solution of this application, deformation capabilities of the first region and the second region may be different by adjusting a physical attribute of the support structure. The physical attribute of the support structure includes a height of the support structure, a diameter of the support structure, and a density of the support structure.

It should be understood that the physical attribute of the support structure is not limited to the foregoing enumerated attributes, and manners that can make the first region and the second region have different deformation capabilities fall within the protection scope of this application. This is not strictly limited.

Therefore, the housing can be divided into the first region and the second region by adjusting a related parameter of the support structure, so that the second region has the greater deformation capability than the first region and can provide the deformation space for the coolant, and the coolant has a specific compression and relaxation space. Specifically, when a temperature of the coolant increases and the coolant expands, a cavity wall of the accommodation cavity expands, and an outer surface of the second region is driven to protrude, thereby effectively absorbing volume expansion of the coolant when the temperature of the coolant increases. When the temperature of the coolant decreases and the coolant shrinks, the cavity wall of the accommodation cavity shrinks, and the outer surface of the second region is driven to be depressed, thereby effectively adapting to volume shrinkage when the temperature of the coolant decreases.

In this arrangement, the volume change of the coolant caused by the temperature change is fully considered when the parameter of the support structure is set. Possibilities of problems in the conventional technology such as a large stress generated by a liquid cooling plate due to no deformation space for a coolant, or a structure is damaged because the liquid cooling plate expands at a weakest position and a surrounding component at the weakest position of the structure is interfered are minimized. In this way, the overall liquid cooling plate has the good mechanical strength, and the working reliability of the liquid cooling plate is effectively improved.

In a possible implementation, a bending stiffness of the second region is less than a bending stiffness of the first region.

Therefore, the second region is more easily deformed than the first region, and has a greater deformation capability. In this arrangement, the housing has two parts with different deformation capabilities, so that the first region with greater bending stiffness can provide strong support for the mechanical strength of the liquid cooling plate, and the second region with smaller bending stiffness can provide suitable deformation space for deformation of the coolant. Therefore, the liquid cooling plate has high strength without cracking in a high-temperature environment or a low-temperature environment, and has good working reliability. This is beneficial to dual performance of high strength and lightweight of the overall liquid cooling plate, and an application range is wide.

In a possible implementation, the support structure includes a plurality of first support columns, the plurality of first support columns are arranged in the first region at intervals, and the plurality of first support columns are all connected between the top wall and the bottom wall. That is, each first support column is supported between the top wall and the bottom wall, and can provide strong support for the mechanical strength of the liquid cooling plate. For example, the plurality of first support columns are evenly arranged in the first region. A cross-sectional form of the first support column may include one or a combination of a plurality of shapes such as a rectangle, a circle, and a diamond. The shape of the first support column may be flexibly adjusted based on an actual situation, and this is not strictly limited.

In a possible implementation, the support structure is further disposed in the second region, the support structure includes a plurality of first support columns and a plurality of second support columns, the plurality of first support columns are arranged in the first region at intervals, and the plurality of second support columns are arranged in the second region at intervals.

The plurality of first support columns and the plurality of second support columns are all connected between the top wall and the bottom wall, and a spacing between two adjacent first support columns is less than a spacing between two adjacent second support columns.

That is, each first support column is supported between the top wall and the bottom wall, and can provide strong support for the mechanical strength of the liquid cooling plate. For example, the plurality of first support columns are evenly arranged in the first region. A cross-sectional form of the first support column may include one or a combination of a plurality of shapes such as a rectangle, a circle, and a diamond. The shape of the first support column may be flexibly adjusted based on an actual situation, and this is not strictly limited.

Each second support column is supported between the top wall and the bottom wall, and can provide strong support for the mechanical strength of the liquid cooling plate. For example, the plurality of second support columns are evenly arranged in the second region. A cross-sectional form of the second support column may include one or a combination of a plurality of shapes such as a rectangle, a circle, and a diamond. The shape of the second support column may be flexibly adjusted based on an actual situation, and this is not strictly limited.

For example, the first support column and the second support column may be manufactured through etching, stamping, or the like. The first support column and the second support column may be disposed on the top cover plate at the same time, and are connected to the bottom cover plate through brazing, laser welding, or the like. Alternatively, the first support column and the second support column may be disposed on the bottom cover plate at the same time, and are connected to the top cover plate through brazing, laser welding, or the like. Alternatively, the first support column may be disposed on one of the top cover plate and the bottom cover plate, and the second support column may be disposed on the other of the top cover plate and the bottom cover plate. The first support column is connected to the corresponding cover plate and the second support column is connected to the corresponding cover plate through brazing, laser welding, or the like.

In this implementation, the housing can be divided into the first region and the second region by adjusting relative densities of the first support columns and the second support columns.

Specifically, the spacing between two adjacent first support columns is less than the spacing between two adjacent second support columns. That is, a density (dense degree) of the support columns in the second region is less than a density (dense degree) of the support columns in the non-expansion region. In other words, by comparing the two, the first region in which the plurality of first support columns are located is a high-density region in which the support columns are dense, and the second region in which the plurality of second support columns are located is a low-density region in which the support columns are sparsely arranged. "High" and "low" in the high-density region and the low-density region represent relative concepts between the two, and represent only relative densities of the support columns in the two regions, but not absolute densities of the support columns in the two regions. The high-density region and the low-density region are relative. That is, if there are two regions with different densities of the support columns in the housing, the region with a higher density is the high density region, and the region with a lower density is the low density region.

For example, the second support column is disposed on only a periphery of the second region and is connected between the top wall and the bottom wall, and the second support column is not disposed in a center of the second region.

Alternatively, the second support column is disposed in only the center of the second region and is connected between the top wall and the bottom wall, and the second support column is not disposed on the periphery of the second region.

Therefore, the support columns in the second region adopt a sparse position design by reducing a quantity of the support columns, and the second region can be made into a deformable region with soft strength, thereby effectively reducing the local bending stiffness of the second region, so that the second region has a greater deformation capability than the first region, and absorbs volume and pressure changes of the liquid coolant in the accommodation cavity through moderate deformation. In addition, the support columns in the first region adopt a dense position design, so that the first region can be made into a hard and less deformable region, thereby effectively improving the local bending stiffness of the first region, so that the first region has a smaller deformation capability than the second region, and provides better mechanical strength for the overall liquid cooling plate and ensure the reliability of the liquid cooling plate during operation.

In a possible implementation, the support structure is further disposed in the second region. The support structure includes a plurality of first support columns and a plurality of second support columns, the plurality of first support columns are arranged in the first region at intervals, and the plurality of second support columns are arranged in the second region at intervals.

The plurality of first support columns are all connected between the top wall and the bottom wall, one end of one or more of the plurality of second support columns is connected to the bottom wall, and the other end is spaced apart from the top wall.

That is, each first support column is supported between the top wall and the bottom wall, and can provide strong support for the mechanical strength of the liquid cooling plate. For example, the plurality of first support columns are evenly arranged in the first region. A cross-sectional form of the first support column may include one or a combination of a plurality of shapes such as a rectangle, a circle, and a diamond. The shape of the first support column may be flexibly adjusted based on an actual situation, and this is not strictly limited.

For example, the first support column and the second support column may be manufactured through etching, stamping, or the like. The first support column and the second support column may be disposed on the top cover plate at the same time, and are connected to the bottom cover plate through brazing, laser welding, or the like. Alternatively, the first support column and the second support column may be disposed on the bottom cover plate at the same time, and are connected to the top cover plate through brazing, laser welding, or the like. Alternatively, the first support column may be disposed on one of the top cover plate and the bottom cover plate, and the second support column may be disposed on the other of the top cover plate and the bottom cover plate. The first support column is connected to the corresponding cover plate and the second support column is connected to the corresponding cover plate through brazing, laser welding, or the like. In addition, in this embodiment, the spacing between two adjacent first support columns may be equal to the spacing between two adjacent second support columns. That is, the density (dense degree) of the second support columns in the second region is the same as the density (dense degree) of the first support columns in the first region.

In the technical solution of this application, the housing can be divided into the first region and the second region by adjusting heights of the first support columns and the second support columns.

Specifically, in the first region, heights of the plurality of first support columns are adapted to a vertical distance between the top wall and the bottom wall. However, in the second region, heights of one or more of the plurality of second support columns may not be adapted to the vertical distance between the top wall and the bottom wall.

Therefore, one end of the support column in the second region may not form a connection and support relationship with the corresponding cover plate by reducing the height of the support column, and the second region can be made into a deformable region with soft strength, thereby effectively reducing the local bending stiffness of the second region, so that the second region has a greater deformation capability than the first region, and absorbs volume and pressure changes of the liquid coolant in the accommodation cavity through moderate deformation. In addition, the support column in the first region is supported between the top wall and the bottom wall, so that the first region can be made into a hard and less deformable region, thereby effectively improving the local bending stiffness of the first region, so that the first region has a smaller deformation capability than the second region, and can provide better mechanical strength for the overall liquid cooling plate and ensure the reliability of the liquid cooling plate during operation.

In a possible implementation, heights of the plurality of second support columns whose other ends are spaced apart from the top wall are the same, and the height is a size of the second support column in a direction perpendicular to the housing; or
heights of the plurality of second support columns whose other ends are spaced apart from the top wall are different, and the height is a size of the second support column in a direction perpendicular to the housing.

For example, second support columns located on outer peripheries are connected between the top wall and the bottom wall. One end of second support columns located in a center is connected to the bottom wall, the other end is spaced apart from the bottom wall, and heights of the second support columns located in the center are the same.

That is, heights of the second support columns located on outer peripheries are greater than the heights of the second support columns located in the center, and the heights of the second support columns located in the center are the same. The height refers to a length from one end that is of the support column and that is connected to the bottom cover plate to the other end that is away from the bottom cover plate, in other words, a size of the support column in a direction perpendicular to the housing. In other words, among all the second support columns, heights of second support columns whose heights are not adapted to a distance between the top cover plate and the bottom cover plate may be the same.

For example, second support columns located on outer peripheries are connected between the top wall and the bottom wall. One end of second support columns located in the center is connected to the bottom wall, the other end is spaced apart from the bottom wall, and heights of the second support columns located in the center are different.

That is, heights of the second support columns located on outer peripheries are greater than the heights of the second support columns located in the center, and the heights of the second support columns located in the center are different. The height refers to a length from one end that is of the support column and that is connected to the bottom cover plate to the other end that is away from the bottom cover plate, in other words, a size of the support column in a direction perpendicular to the housing. In other words, among all the second support columns, the heights of the second support columns whose heights are not adapted to the distance between the top cover plate and the bottom cover plate may be different. For example, the heights of the second support columns in the center may be arranged in a gradient manner, or the heights of the second support columns in the center may be arranged symmetrically about the center.

For example, one end of the second support columns located in the second region is connected to the bottom cover plate, the other end is spaced apart from the top cover plate, and heights of the second support columns are the same. The height refers to a length from one end that is of the support column and that is connected to the bottom cover plate to the other end that is away from the bottom cover plate, in other words, the size of the support column in the direction perpendicular to the housing.

For example, one end of the second support columns located in the second region is connected to the bottom cover plate, the other end is spaced apart from the top cover plate, and heights of the second support columns are different. The height refers to a length from one end that is of the support column and that is connected to the bottom cover plate to the other end that is away from the bottom cover plate, in other words, the size of the support column in the direction perpendicular to the housing.

It should be noted that heights and positions of the second support columns are not limited to the cases described above, and the positions and the heights of the second support columns may be flexibly set based on an expansion situation that the second region actually needs to meet, provided that the second region can absorb thermal expansion and contraction of the coolant. This is not strictly limited in this embodiment.

In a possible implementation, a groove is disposed on an outer surface of the first support column and/or an outer surface of the second support column, or a protrusion is disposed on an outer surface of the first support column and/or an outer surface of the second support column.

Therefore, a contact area between the coolant and the support columns can be increased, so that the coolant can fully contact the liquid cooling plate, thereby achieving good heat dissipation and cooling effect.

In a possible implementation, the first region is used to contact the heat generating device.

In this embodiment of this application, the housing of the liquid cooling plate needs to be in direct or indirect contact with the heat generating device, so that heat of the heat generating device can be conducted to the liquid cooling plate, and the heat is taken away by using the coolant flowing in the liquid cooling plate. In other words, the heat generating device directly or indirectly contacts the first region.

In this arrangement, the heat generating device contacts the housing at a proper position. This not only enables the liquid cooling plate to maintain good sealing property, but also enables the coolant in the liquid cooling plate to keep a smooth path for liquid cooling to flow.

For example, the heat generating device may be in contact with the housing by using a thermally conductive structure. The thermally conductive structure may be but is not limited to a thermally conductive silicone grease, a thermal adhesive, a thermal pad, or the like. Therefore, a good thermal conductivity of the thermally conductive structure allows the heat generating device and the liquid cooling plate to be in close contact to form a region with good thermal conductivity. This helps better implement a heat dissipation and cooling function and good reliability of the liquid cooling plate.

Alternatively, the heat generating device may be connected to a vapor chamber by using the thermally conductive structure, and then the vapor chamber is connected to the liquid cooling plate. The thermally conductive structure may be but is not limited to the thermally conductive silicone grease, the thermal adhesive, the thermal pad, or the like. Therefore, a heat transfer path of "the heat generating device-the vapor chamber-the liquid cooling plate" can be realized. The heat of the heat generating device can be effectively expanded through a good heat expansion capability of the vapor chamber. In this way, the heat of the heat generating device is fully transferred to the liquid cooling plate. This helps reduce heat conduction resistance, so that the liquid cooling plate has a good heat conduction temperature difference and heat transfer efficiency, and heat conduction performance of the liquid cooling plate is effectively improved.

It should be understood that a connection manner between the vapor chamber and the liquid cooling plate includes bonding together by using thermally conductive silicone gel, thermally conductive silicone grease, or the like, and also includes welding together by using solder. A relative position relationship between the vapor chamber and the liquid cooling plate may be that the vapor chamber and the liquid cooling plate are vertically stacked or share one wall surface. This is not strictly limited.

In another possible implementation, the second region may be disposed in a staggered manner with the second region.

It may be understood that, a part where the heat generating device contacts the housing needs to avoid deformation as much as possible. However, the second region of the housing is correspondingly deformed when the temperature changes, and a form of the second region changes with a form of the coolant due to thermal expansion and contraction. Therefore, the heat generating device needs to be disposed in a staggered manner with the second region, in other words, the heat generating device needs to be disposed in the second region.

Therefore, the second region and the heat generating device are disposed in a staggered manner to ensure that a deformation capability of the second region is not interfered. Mechanical strength of the second region is low. Therefore, the second region may be properly deformed to facilitate installation and adjustment, and when the temperature of the coolant is high, the second region may be properly deformed to relieve the pressure of the coolant in the liquid cooling plate. Flexibility is strong and an application range is wide.

It should be noted that one or more heat generating devices may be disposed. When there are a plurality of heat generating devices, the plurality of heat generating devices and the second region need to be disposed in a staggered manner as much as possible, so as to avoid deformation of a region in which the heat generating devices are disposed, which may interfere with a capability of absorbing thermal expansion and contraction of the coolant in the second region. Certainly, the heat generating device may alternatively be not disposed in a staggered manner with the second region.

A second aspect of this application provides a liquid cooling system. The liquid cooling system includes a delivery apparatus and the foregoing liquid cooling plate. The delivery apparatus is connected to the liquid cooling plate, and is configured to drive a coolant to flow in the liquid cooling plate.

The liquid cooling plate is a key component of the liquid cooling system. In a use process, the liquid cooling plate should be placed as close as possible to a heat generating device such as a high-power chip, so that the coolant inside the liquid cooling plate performs heat exchange with the heat generating device, to dissipate heat from and cool the heat generating device and ensure that the liquid cooling system has good heat dissipation effect. That is, the liquid cooling plate can directly or indirectly contact the heat generating device, and dissipate heat to an external environment of an electronic device by using the coolant flowing in the liquid cooling plate.

The delivery apparatus can provide power for the coolant, and drive the coolant to circulate and flow inside the liquid cooling system to take away heat of the heat generating device. For example, the delivery apparatus may be an electronic liquid pump.

A rotating shaft pipe can be connected between the liquid cooling plate and the delivery apparatus, or the rotating shaft pipe can be connected between two liquid cooling plates to transfer the coolant.

In a specific application scenario, there are two liquid cooling plates, which are respectively a screen-side cooling plate and a keyboard-side cooling plate. The screen-side cooling plate is a liquid cooling plate disposed on a screen side of a notebook computer. The keyboard-side cooling plate is a liquid cooling plate disposed on a keyboard side of the notebook computer. The keyboard-side cooling plate directly or indirectly contacts the heat generating device, and can carry heat of the heat generating device by using the coolant flowing in the keyboard-side cooling plate. The screen-side cooling plate has a large area, and can dissipate heat carried by the coolant flowing in the liquid cooling system and heat generated when the screen works to the external environment of the electronic device by using a housing on the screen side.

There are two rotating shaft pipes. One rotating shaft pipe is disposed between the screen-side liquid cooling plate and the keyboard-side liquid cooling plate, and the other rotating shaft pipe is disposed between the screen-side liquid cooling plate and the delivery apparatus. The liquid cooling system further includes a plurality of fluid pipes. The plurality of fluid pipes are disposed in a plurality of positions, such as inside the rotating shaft pipe, between the keyboard-side liquid cooling plate and the delivery apparatus, between the rotating shaft pipe and the keyboard-side cooling plate, and between the rotating shaft pipe and the delivery apparatus, as required, so that the screen-side liquid cooling plate, the keyboard-side liquid cooling plate, the delivery apparatus and the rotating shaft pipe are communicated with each other to form a closed circulation system in which the coolant circulates and flows.

Therefore, a circulation path of "the delivery apparatus-the rotating shaft pipe-the screen-side cooling plate-the rotating shaft pipe-the keyboard-side cooling plate-the delivery apparatus" can be formed inside the liquid cooling system. The keyboard-side cooling plate can directly contact the heat generating device, and power consumption on the screen side is small. Therefore, the coolant can carry the heat of the heat generating device when flowing to the keyboard-side cooling plate in a circulation process between the keyboard-side cooling plate and the screen-side cooling plate. In addition, cooling is performed when the coolant flows to the screen-side cooling plate, so that the overall electronic device maintains good temperature uniformity performance.

According to a third aspect of this application, an electronic device is provided. The electronic device includes a housing and the foregoing liquid cooling system, and the liquid cooling system is located inside the housing.

For example, the electronic device may be a mobile phone, a tablet computer, a notebook computer, an augmented reality (Augmented Reality, AR) device, a virtual reality (Virtual Reality, VR) device, or the like.

### BRIEF DESCRIPTION OF DRAWINGS

FIG. 1 is a schematic diagram of a structure of an electronic device according to an embodiment of this application;
FIG. 2 is a schematic diagram of a structure of a liquid cooling system according to an embodiment of this application;
FIG. 3 is a schematic diagram of a partial structure of an electronic device according to an embodiment of this application;
FIG. 4 is a schematic diagram of a structure of a liquid cooling plate according to an embodiment of this application;
FIG. 5 is a schematic diagram of a structure of a liquid cooling plate according to Embodiment 3 of this application;
FIG. 6 is a schematic diagram of a structure of a bottom cover plate of the liquid cooling plate shown in FIG. 5;
FIG. 7 is a schematic diagram of a structure of another liquid cooling plate according to Embodiment 3 of this application;
FIG. 8 is a schematic diagram of a partial structure of a liquid cooling plate according to Embodiment 1 of this application;
FIG. 9 is another schematic diagram of a partial structure of a liquid cooling plate according to Embodiment 1 of this application;
FIG. 10 is a schematic cross-sectional view of a liquid cooling plate according to Embodiment 1 of this application;
FIG. 11 is another schematic cross-sectional view of a liquid cooling plate according to Embodiment 1 of this application;
FIG. 12 is a schematic diagram of a partial structure of a liquid cooling plate according to Embodiment 2 of this application;
FIG. 13 is a schematic cross-sectional view of a liquid cooling plate according to Embodiment 2 of this application;
FIG. 14 is another schematic cross-sectional view of a liquid cooling plate according to Embodiment 2 of this application;
FIG. 15 is still another schematic cross-sectional view of a liquid cooling plate according to Embodiment 2 of this application; and
FIG. 16 is yet another schematic cross-sectional view of a liquid cooling plate according to Embodiment 2 of this application.

### DESCRIPTION OF EMBODIMENTS

For ease of understanding, terms in embodiments of this application are first explained.

"And/or" is merely an association relationship for describing associated objects and represents that three relationships may exist. For example, A and/or B may represent the following three cases: Only A exists, both A and B exist, and only B exists.

"A plurality of" means two or more than two.

"Connection" should be understood in a broad sense. For example, if A and B are connected, A and B may be directly connected, or A and B may be indirectly connected through an intermediate medium.

The following clearly describes specific implementations of this application with reference to accompanying drawings.

Currently, most terminal and quasi-terminal products, such as a notebook computer and a mobile phone, adopt natural heat dissipation to resolve a heat dissipation problem. As the terminal and quasi-terminal products develop towards light, thin, small, and easy to carry, liquid cooling can improve a heat dissipation capability of the terminal products. Due to a small size of the terminal product, a volume of a liquid cooling plate needs to be reduced accordingly. Therefore, how to realize lightness and high strength of the liquid cooling plate has gradually become a key technology. At present, an ultra-thin cooling plate is weak in mechanical strength, and problems of cooling plate bulging and coolant leakage may occur due to volume expansion when a temperature of a liquid coolant is high. This may interfere with operation of a device and causes a fault in a severe case.

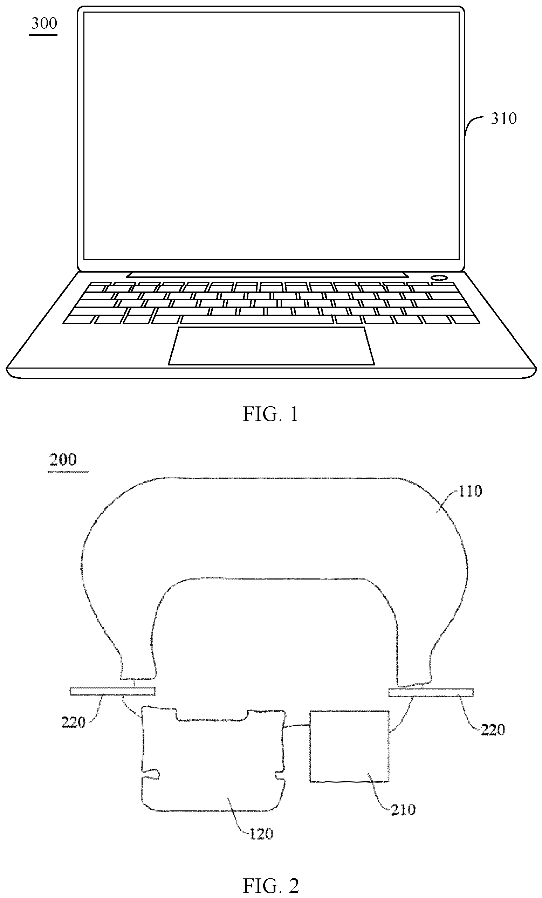

Based on this, with reference to FIG. 1, FIG. 2, and FIG. 3, embodiments of this application provide a liquid cooling plate 100, a liquid cooling system 200 to which the liquid cooling plate 100 is applied, and an electronic device 300 to which the liquid cooling system 200 is applied. Under the development trend of miniaturization, and lightness and thinning of the liquid cooling plate 100, a volume change of a liquid coolant in the liquid cooling plate 100 can be absorbed, pressure inside the liquid cooling system 200 can be reduced, and impact of the volume change of the coolant on working reliability of the liquid cooling plate 100, the liquid cooling system 200, and peripheral components is reduced.

The liquid cooling plate 100 may be used in any electronic device 300 that needs to prepare a light and thin cooling plate having a deformation capability to absorb thermal expansion and contraction of a coolant. For example, the electronic device 300 may be an intelligent consumer electronic device such as a mobile phone, a tablet computer, or a notebook computer. Alternatively, the electronic device 300 may be a wearable device such as an augmented reality (Augmented Reality, AR) device, a virtual reality (Virtual Reality, VR) device, smart glasses, smart goggles, smart watches, smart bands, head-mounted wireless headsets, bone conduction wireless headsets, neckband wireless headsets, or true wireless stereo (True Wireless Stereo, TWS) headsets.

For ease of understanding, the following uses an electronic device 300 that is widely used and rich in application scenarios, such as a notebook computer, as an example for description, but is not limited thereto.

Refer to FIG. 1, FIG. 2, and FIG. 3. The electronic device 300 includes a housing 310, and a heat generating device 320 and the liquid cooling system 200 that are disposed inside the housing 310.

The housing 310 is an appearance structure of the electronic device 300, and can accommodate and package various components of the electronic device 300, so that the various components of the electronic device 300 are protected from external dust, water vapor, and the like. The housing 310 has a good protection function.

The heat generating device 320 is a component that generates heat in a working process of the electronic device 300. A quantity of heat generating devices 320 may be selected based on an actual situation, and there may be one or more heat generating devices 320. To be specific, when there is one heat generating device 320, the liquid cooling system 200 may dissipate heat from a single heat source. When there are a plurality of heat generating devices 320, the liquid cooling system 200 may dissipate heat from a plurality of heat sources. The quantity and a position layout of the heat generating devices 320 may be flexibly adjusted based on a hardware form, a layout, a use scenario, and the like of the electronic device 300. This is not strictly limited in this embodiment of this application. Therefore, the liquid cooling system 200 can meet heat dissipation requirements of a single heat source and a plurality of heat sources, and can be more suitable for multi-scenario application, thereby helping improve comprehensive performance of the electronic device 300. For example, the heat generating device 320 may be a chip, a central processing unit (Central Processing Unit, CPU), a graphics processing unit (Graphics Processing Unit, GPU), a wireless module, a battery, a high-power-consumption inductor, a capacitor, or the like.

It may be understood that, in the working process of the electronic device 300, the heat generating device 320 is used as a heat emitting element to generate a large amount of heat, so that a hot spot is formed at a corresponding position inside the electronic device 300. A temperature of the hot spot is high. If heat generated by the hot spot is not effectively dissipated in time, working performance of the electronic device 300 is directly affected. For example, if local overheating occurs, the electronic device 300 fails. In addition, a temperature of the housing 310 at the position corresponding to the hot spot is correspondingly high. As a result, the housing 310 is partially overheated, and user experience is seriously affected. In other words, a heat balance condition of the electronic device 300 directly affects the working performance of the electronic device 300.

Based on this, the liquid cooling system 200 is disposed inside the electronic device 300, so that a problem that the electronic device 300 fails due to a large amount of heat generated by the heat generating device 320 can be effectively resolved, and the electronic device 300 has excellent heat dissipation performance.

The overall liquid cooling system 200 uses a coolant (not shown in the figure) as a heat exchange medium, and the coolant flows in the system to take away heat generated by the heat generating device 320, thereby implementing heat dissipation and cooling of a precision device. It should be understood that the coolant may be any coolant with a property of thermal expansion and contraction. This is not specifically limited in this embodiment of this application. For example, the coolant may be but is not limited to ethylene glycol (Ethylene Glycol, EG), fluorinated liquid FC-3283, Galden^{®} PFPE, deionized water, or liquid metal. The coolant can expand by 10% in volume from a normal temperature to a high temperature, and shrink by 10% in volume from the normal temperature to a low temperature.

It should be noted that the liquid cooling system 200 may be further used in an optical module, a wearable device, or a precision device such as a radar, a communication device, or a laser device, to meet a heat dissipation requirement of the heat generating device 320 such as a high-power chip. This is not strictly limited in this embodiment of this application.

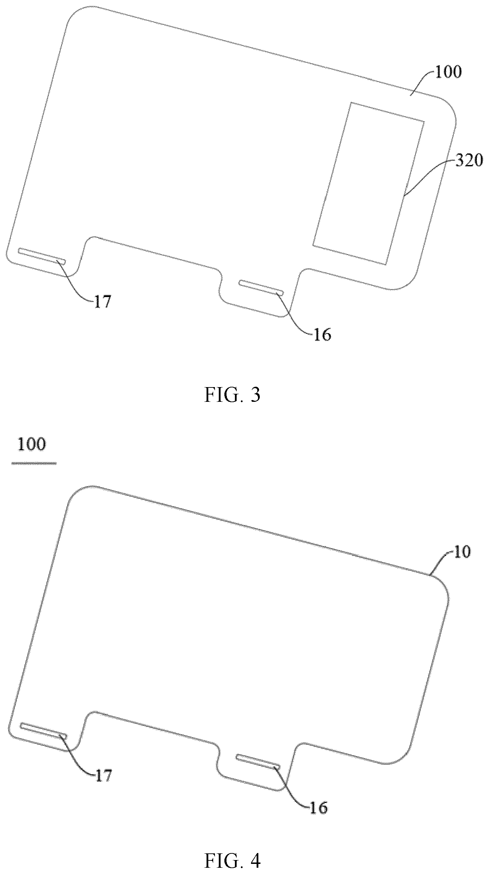

Refer to FIG. 2 and FIG. 3. The liquid cooling system 200 includes the liquid cooling plate 100, a delivery apparatus 210, and a rotating shaft pipe 220.

The liquid cooling plate 100 is a key component of the liquid cooling system 200. In a use process, the liquid cooling plate 100 should be placed as close as possible to the heat generating device 320 such as the high-power chip, so that the coolant inside the liquid cooling plate 100 performs heat exchange with the heat generating device 320, to dissipate heat from and cool the heat generating device 320, and ensure that the liquid cooling system 200 has good heat dissipation effect. To be specific, the liquid cooling plate 100 can directly or indirectly contact the heat generating device 320, and dissipate heat to an external environment of the electronic device 300 by using the coolant flowing in the liquid cooling plate 100.

The delivery apparatus 210 can provide power for the coolant, and drive the coolant to circulate and flow inside the liquid cooling system 200 to take away heat of the heat generating device 320. For example, the delivery apparatus 210 may be an electronic liquid pump.

The rotating shaft pipe 220 can be connected between the liquid cooling plate 100 and the delivery apparatus 210, or the rotating shaft pipe 220 can be connected between two liquid cooling plates 100, to transfer the coolant.

It should be noted that FIG. 2 is merely intended to schematically describe a connection relationship among the liquid cooling plate 100, the delivery apparatus 210, and the rotating shaft pipe 220, and is not intended to specifically limit a connection position, a specific structure, and a quantity of the devices. The structure shown in this embodiment of this application does not constitute a specific limitation on the liquid cooling system 200. In some other embodiments of this application, the liquid cooling system 200 may include more or fewer components than those shown in the figure, or some components may be combined, or some components may be split, or different component arrangements may be used. The components shown in the figure may be implemented by hardware, software, or a combination of software and hardware.

Refer to FIG. 1, FIG. 2, and FIG. 3. In a specific application scenario, there are two liquid cooling plates 100, which are respectively a screen-side cooling plate 110 and a keyboard-side cooling plate 120. The screen-side cooling plate 110 is a liquid cooling plate 100 disposed on a screen side of the notebook computer, and the keyboard-side cooling plate 120 is a liquid cooling plate 100 disposed on a keyboard side of the notebook computer. The keyboard-side cooling plate 120 directly or indirectly contacts the heat generating device 320, and can carry heat of the heat generating device 320 by using the coolant flowing in the keyboard-side cooling plate 120. The screen-side cooling plate 110 has a large area, and can dissipate heat carried by the coolant flowing in the liquid cooling system 200 and heat generated when a screen works to the external environment of the electronic device 300 by using the housing 310 on the screen side.

There are two rotating shaft pipes 220. One rotating shaft pipe 220 is disposed between the screen-side cooling plate 110 and the keyboard-side cooling plate 120, and the other rotating shaft pipe 220 is disposed between the screen-side cooling plate 110 and the delivery apparatus 210. The liquid cooling system 200 further includes a plurality of fluid pipes 230. The plurality of fluid pipes 230 are disposed in a plurality of positions, such as inside the rotating shaft pipe 220, between the keyboard-side cooling plate 120 and the delivery apparatus 210, between the rotating shaft pipe 220 and the keyboard-side cooling plate 120, and between the rotating shaft pipe 220 and the delivery apparatus 210, as required, so that the screen-side cooling plate 110, the keyboard-side cooling plate 120, the delivery apparatus 210, and the rotating shaft pipe 220 are communicated with each other to form a closed circulation system in which the coolant circulates and flows.

Therefore, a circulation path of "the delivery apparatus 210-the rotating shaft pipe 220-the screen-side cooling plate 110-the rotating shaft pipe 220-the keyboard-side cooling plate 120-the delivery apparatus 210" can be formed inside the liquid cooling system 200. The keyboard-side cooling plate 120 can directly contact the heat generating device 320, and power consumption on the screen side is small. Therefore, the coolant can carry the heat of the heat generating device 320 when flowing to the keyboard-side cooling plate 120 in a circulation process between the keyboard-side cooling plate 120 and the screen-side cooling plate 110. In addition, cooling is performed when the coolant flows to the screen-side cooling plate 110, so that the overall electronic device 300 maintains good temperature uniformity performance.

Basic composition of the liquid cooling system 200 is described above. The following describes in detail a structure of the liquid cooling plate 100 provided in this embodiment of this application with reference to FIG. 3 to FIG. 9. A specific structure of the liquid cooling plate 100 described below may be applied to the screen-side cooling plate 110, and may alternatively be applied to the keyboard-side cooling plate 120. This is not strictly limited in this embodiment of this application.

Refer to FIG. 3 to FIG. 9. The liquid cooling plate 100 includes a housing 10, the coolant flowing in the housing 10, and a support structure 20 disposed in the housing 10.

It may be understood that, the coolant undergoes thermal expansion and contraction when the temperature changes, in other words, the coolant can expand in volume when being heated and shrink in volume when being cooled. If there is no space inside the liquid cooling plate 100 for deformation of the coolant, the coolant is almost incompressible. This may cause a large stress to damage the liquid cooling plate 100, or the liquid cooling plate 100 may expand at a weakest position, which may interfere with a surrounding component at the weakest position of the structure, and may cause structural damage. Therefore, when the coolant flows inside the liquid cooling plate 100, a volume change of the coolant caused by a temperature change needs to be considered when a structure of the liquid cooling plate 100 is set, so that the overall liquid cooling plate 100 has good mechanical strength, and working reliability of the liquid cooling plate 100 is improved.

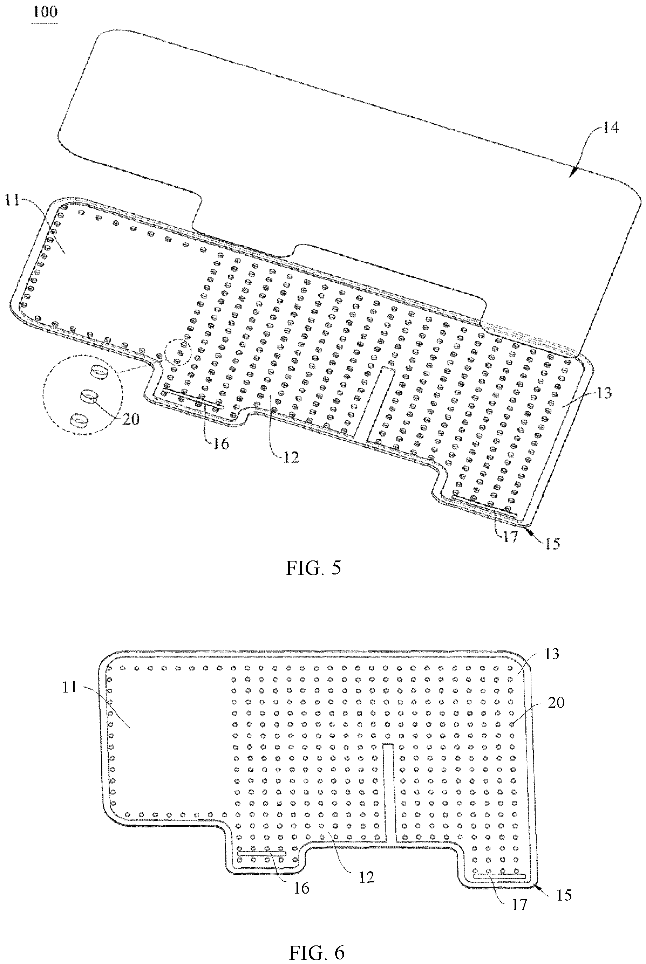

Therefore, with reference to FIG. 5, FIG. 6, FIG. 7, FIG. 8, and FIG. 9, the housing 10 includes a top cover plate 14 and a bottom cover plate 15. The top cover plate 14 and the bottom cover plate 15 jointly form an appearance form of the liquid cooling plate 100, and cooperate to form an accommodation cavity 13. It should be understood that an inner wall of the top cover plate 14 may form one of a top wall 131 of the housing 10 or a bottom wall 132 of the housing 10, and an inner wall of the bottom cover plate 15 may form the other of the top wall 131 of the housing 10 or the bottom wall 132 of the housing 10. The top wall 131 of the housing 10 and the bottom wall 132 of the housing 10 are a top wall of the accommodation cavity 13 and a bottom wall of the accommodation cavity 13.

For example, the top cover plate 14 may be made of a metal material, and the metal material may be but is not limited to copper, stainless steel, titanium, aluminum, or the like. Different materials may be selected based on a lightweight requirement, a welding difficulty requirement, a costs requirement and a thermal conductivity requirement. For example, titanium is available for a lightweight material, stainless steel is available for a low-cost material that is easy to weld, and copper is available for a material with good thermal conductivity. This is not strictly limited herein. A thickness of the top cover plate 14 may range from 0.01 mm (millimeter) to 2 mm (millimeter).

The bottom cover plate 15 may be made of a metal material, and the metal material may be but is not limited to copper, stainless steel, titanium, aluminum, or the like. Different materials may be selected based on a lightweight requirement, a welding difficulty requirement, a costs requirement and a thermal conductivity requirement. For example, titanium is available for a lightweight material, stainless steel is available for a low-cost material that is easy to weld, and copper is available for a material with good thermal conductivity. This is not strictly limited herein. A thickness of the bottom cover plate 15 may range from 0.01 mm (millimeter) to 2 mm (millimeter).

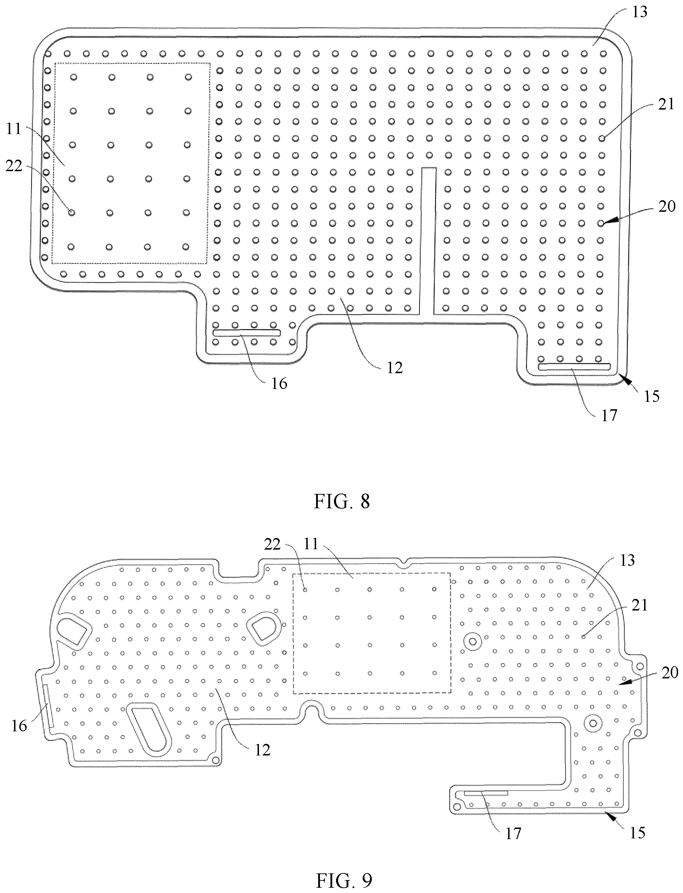

The accommodation cavity 13 includes a first region 12 and a second region 11. The second region 11 can deform to absorb the volume variation of the coolant. It should be noted that in FIG. 5, FIG. 6, and FIG. 7, a blank part in which the support structure 20 is not disposed is the second region 11, and a part in which the support structure 20 is disposed is the first region 12. In FIG. 8 and FIG. 9, an inner part of a dotted box is the second region 11, and a part outside of the dotted box is the first region 12.

It should be understood that the volume change of the coolant includes volume expansion caused by a temperature increase of the coolant due to heat absorption, and volume shrinkage caused by a temperature decrease of the coolant due to cooling. Based on this, deformation of the second region 11 includes both volume expansion caused by adapting to volume expansion of the coolant and volume shrinkage caused by adapting to volume shrinkage of the coolant.

The accommodation cavity 13 is divided into two regions: the first region 12 and the second region 11 based on different functions of the two regions. A structure for ensuring mechanical strength of the overall liquid cooling plate 100 is disposed in the first region 12, and a structure capable of providing a deformation space adapted to the volume variation of the coolant due to thermal expansion and contraction is disposed in the second region 11.

In this arrangement, the liquid cooling plate 100 has high strength while maintaining a small volume. This helps reduce a thickness of the liquid cooling plate 100 to a maximum extent under the development trend of miniaturization of the electronic device 300, and effectively implement lightness and thinning of the liquid cooling plate 100. In addition, when the coolant flows in the liquid cooling plate 100, the volume change of the coolant caused by the temperature change can be fully considered. The second region 11 can absorb the volume variation of the coolant due to a moderate deformation space. The moderate deformation space is provided for the volume change of coolant. Possibilities of problems in a conventional technology such as cooling plate bulging and coolant leakage caused by volume expansion of the liquid coolant due to a high temperature are minimized, and the working reliability of the liquid cooling plate 100 is good.

That is, the liquid cooling plate 100 in this embodiment of this application has advantages of being light and thin and absorbing thermal expansion and contraction of the coolant through proper deformation on the basis of high strength. Therefore, under the development trend of miniaturization of the liquid cooling plate 100, the thickness of the liquid cooling plate 100 may be further reduced to realize thinness of the liquid cooling plate 100.

It should be noted that division of the first region 12 and the second region 11 indicates that the second region 11 is a part specially designed to be easy to deform, and the first region 12 is a part specially designed to be difficult to deform and needs to ensure the overall mechanical strength of the liquid cooling plate 100. It does not mean that the first region 12 does not deform, and it does not mean that the second region 11 does not play a role of ensuring the overall mechanical strength of the liquid cooling plate 100. That is, in the housing 10, the first region 12 and the second region 11 have different deformation capabilities and different degrees of mechanical strength that can be provided for the overall housing 10.

In addition, a position relationship between the first region 12 and the second region 11 may be flexibly adjusted based on an actual arrangement of electronic components inside the electronic device 300. The second region 11 should be as close as possible to a region without an object, in other words, there should be as few structures or devices around the second region 11 as possible. Therefore, a specific expansion space for the second region 11 to expand can be reserved around the second region 11, so as to ensure that deformation of the second region 11 does not squeeze or damage a surrounding structure. An area ratio of the second region 11 to the first region 12 may alternatively be adjusted based on an actual situation, provided that the second region 11 can absorb shrinkage and expansion of the coolant. This is not strictly limited.

For example, a bending stiffness of the second region 11 is less than a bending stiffness of the first region 12. Therefore, the second region 11 is more easily deformed than the first region 12, and has a greater deformation capability. In this arrangement, the housing 10 has two parts with different deformation capabilities, so that the first region 12 with greater bending stiffness can provide strong support for the mechanical strength of the liquid cooling plate 100, and the second region 11 with smaller bending stiffness can provide suitable deformation space for deformation of the coolant. Therefore, the liquid cooling plate 100 has high strength without cracking in a high-temperature environment or a low-temperature environment, and has good working reliability. This is beneficial to dual performance of high strength and lightweight of the overall liquid cooling plate 100, and an application range is wide.

Refer to FIG. 2, FIG. 3, FIG. 4, FIG. 5, and FIG. 6. In this embodiment of this application, the housing 10 of the liquid cooling plate 100 needs to directly or indirectly contact the heat generating device 320, so that the heat of the heat generating device 320 can be conducted to the liquid cooling plate 100, and the heat is taken away by the coolant flowing in the liquid cooling plate 100. However, a part where the heat generating device 320 contacts the housing 10 needs to avoid deformation as much as possible. However, as described above, the second region 11 is correspondingly deformed when the temperature changes, and a form of the second region 11 changes with a form of the coolant due to thermal expansion and contraction. Therefore, the heat generating device 320 needs to be disposed in a staggered manner with the second region 11, in other words, the heat generating device 320 needs to be disposed in the second region 11. In other words, the heat generating device 320 directly or indirectly contacts the first region 12.

In this arrangement, the heat generating device 320 contacts the housing 10 at a proper position. This not only enables the liquid cooling plate 100 to maintain good sealing property, but also enables the coolant in the liquid cooling plate 100 to keep a smooth path for liquid cooling to flow. In addition, the second region 11 and the heat generating device 320 are disposed in a staggered manner to ensure that a deformation capability of the second region 11 is not interfered. Mechanical strength of the second region 11 is low. Therefore, the second region 11 may be properly deformed to facilitate installation and adjustment, and when the temperature of the coolant is high, the second region 11 may be properly deformed to relieve the pressure of the coolant in the liquid cooling plate 100. Flexibility is strong and an application range is wide.

It should be noted that one or more heat generating devices 320 may be disposed. When there are a plurality of heat generating devices 320, the plurality of heat generating devices 320 and the second region 11 need to be disposed in a staggered manner as much as possible, so as to avoid deformation of a region in which the heat generating devices 320 are disposed, which may interfere with a capability of absorbing thermal expansion and contraction of the coolant in the second region 11.

In a possible implementation, the heat generating device 320 may be in contact with the housing 10 by using a thermally conductive structure. The thermally conductive structure may be but is not limited to a thermal interface material (TIM, Thermal Interface Material) such as a thermally conductive silicone grease, a thermal adhesive, or a thermal pad. Therefore, a good thermal conductivity of the thermally conductive structure allows the heat generating device 320 and the liquid cooling plate 100 to be in close contact to form a region with good thermal conductivity. This helps better implement a heat dissipation and cooling function and good reliability of the liquid cooling plate 100.

In another possible implementation, the heat generating device 320 may be connected to a vapor chamber (Vapor Chamber, VC) or a heat pipe by using the thermally conductive structure, and the vapor chamber or the heat pipe is connected to the liquid cooling plate 100. The thermally conductive structure may be but is not limited to a thermal interface material such as a thermally conductive silicone grease, a thermal adhesive, or a thermal pad. Therefore, a heat transfer path of "the heat generating device 320-the vapor chamber or the heat pipe-the liquid cooling plate 100" can be realized. The heat of the heat generating device 320 can be effectively expanded through a good heat expansion capability of the vapor chamber. In this way, the heat of the heat generating device 320 is fully transferred to the liquid cooling plate 100. This helps reduce heat conduction resistance, so that the liquid cooling plate 100 has a good heat conduction temperature difference and heat transfer efficiency, and heat conduction performance of the liquid cooling plate 100 is effectively improved.

For example, a connection manner between the vapor chamber and the liquid cooling plate 100 includes bonding together by using thermally conductive silicone gel, thermally conductive silicone grease, or the like, and also includes welding together by using solder. A relative position relationship between the vapor chamber and the liquid cooling plate 100 may be that the vapor chamber and the liquid cooling plate 100 are vertically stacked or share one wall surface. This is not strictly limited.

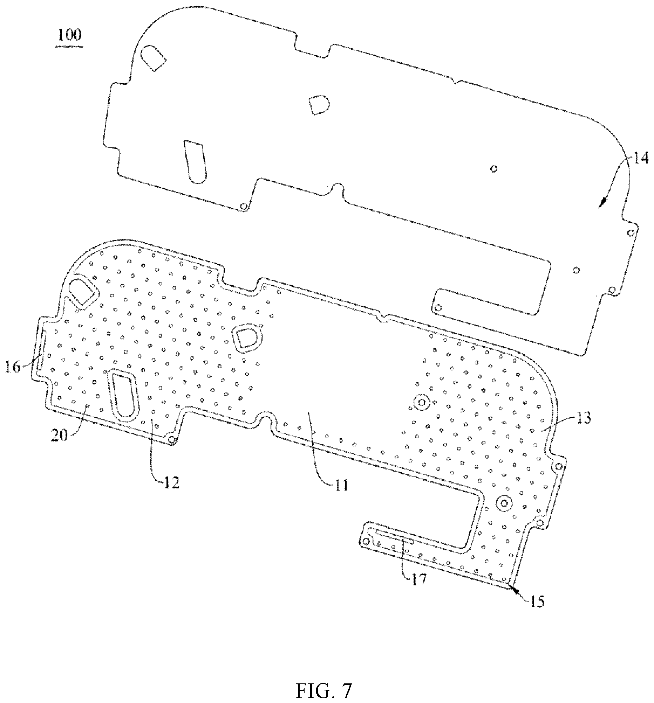

Refer to FIG. 5 and FIG. 7. The accommodation cavity 13 allows the coolant to flow in the accommodation cavity 13, and the accommodation cavity 13 includes the first region 12 and the second region 11.

It should be noted that FIG. 5 and FIG. 7 are merely examples of describing a shape of the housing 10, and the shape of the housing 10 may be flexibly set based on a layout requirement of an internal component of the electronic device 300. The shape of the housing 10 is not strictly limited in this embodiment of this application.

The housing 10 further includes a liquid inlet 16 and a liquid outlet 17, and the liquid inlet 16 communicates with the accommodation cavity 13, so that coolant flowing outside the liquid cooling plate 100 can flow into the liquid cooling plate 100. For example, a shape of the liquid inlet 16 may be one or a combination of a plurality of shapes such as a rectangle, a circle, a triangle, and a diamond. The liquid inlet 16 may be connected to the fluid pipe 230 by using a rotary interface, and then connected to a rotary interface of the delivery apparatus 210 or a rotary interface of the rotating shaft pipe 220 by using the fluid pipe 230. The rotary interface can implement communication between two interfaces of different shapes.

The liquid outlet 17 also communicates with the accommodation cavity 13, so that coolant flowing in the liquid cooling plate 100 can flow out of the liquid cooling plate 100, thereby continuously participating in internal circulation of the liquid cooling system 200. For example, a shape of the liquid outlet 17 may be one or a combination of a plurality of shapes such as a rectangle, a circle, a triangle, and a diamond. The liquid outlet 17 may be connected to the fluid pipe 230 by using the rotary interface, and then connected to the rotary interface of the delivery apparatus 210 or the rotary interface of the rotating shaft pipe 220 by using the fluid pipe 230. The rotary interface can implement communication between two interfaces of different shapes.

It should be understood that, because the coolant needs to flow into the liquid cooling plate 100 from the liquid inlet 16 and flow out of the liquid cooling plate 100 from the liquid outlet 17, there needs to be a specific flow distance between the liquid inlet 16 and the liquid outlet 17. In addition, the coolant needs to flow through the first region 12 and the second region 11, to ensure cooling effect of the liquid cooling plate 100.

Refer to FIG. 5. In a possible implementation, the liquid inlet 16 and the liquid outlet 17 are disposed on a same side, and both the liquid inlet 16 and the liquid outlet 17 are disposed in the first region 12.

Refer to FIG. 7. In another possible implementation, the liquid inlet 16 and the liquid outlet 17 are not disposed on a same side, and both the liquid inlet 16 and the liquid outlet 17 are disposed in the first region 12.

It should be noted that FIG. 5 and FIG. 7 are merely examples of describing shapes of and a position relationship between the liquid inlet 16 and the liquid outlet 17, and the shapes of and an actual position relationship between the liquid inlet 16 and the liquid outlet 17 may be flexibly set based on a layout requirement of the liquid cooling plate 100. This is not strictly limited in this embodiment of this application.

In this embodiment of this application, the top cover plate 14 includes a second region (not shown in the figure) and a first region (not shown in the figure), and the bottom cover plate 15 also includes a first region and a second region. The second region of the top cover plate 14 and the second region of the bottom cover plate 15 are correspondingly disposed and together constitute the second region 11 of the housing 10. The first region of the top cover plate 14 and the first region of the bottom cover plate 15 are correspondingly disposed and together constitute the first region 12 of the housing 10. In addition, the liquid inlet 16 and the liquid outlet 17 may be disposed on the top cover plate 14 or the bottom cover plate 15 as required, and this is not strictly limited.

It may be understood that, the coolant undergoes thermal expansion and contraction when the temperature changes. To adapt to expansion and contraction of the coolant, the second region 11 also expands or shrinks accordingly. In this process, expansion or contraction of the second region 11 may be manifested in a fact that a vertical distance between the top wall 131 and the bottom wall 132 can vary.

Specifically, the volume of the coolant expands when the temperature increases, and the second region 11 expands accordingly to adapt to the volume expansion of the coolant. Expansion of the second region 11 includes a case in which only the top cover plate 14 expands, a case in which only the bottom cover plate 15 expands, and a case in which both the top cover plate 14 and the bottom cover plate 15 expand. During expansion of the second region 11, expansion of the second region 11 may be manifested as a gradually increasing vertical distance between the top wall 131 and the bottom wall 132.

The volume of the coolant shrinks when the temperature decreases, and the second region 11 shrinks accordingly to adapt to volume shrinkage of the coolant. Shrinkage of the second region 11 includes a case in which only the top cover plate 14 shrinks, a case in which only the bottom cover plate 15 shrinks, and a case in which both the top cover plate 14 and the bottom cover plate 15 shrink. During contraction of the second region 11, contraction of the second region 11 may be manifested as a gradually decreasing vertical distance between the top wall 131 and the bottom wall 132.

Expansion of the first region 12 and the second region 11 has been described above, and a formation principle of the first region 12 and the second region 11 is described below with reference to FIG. 5 to FIG. 16.

Refer to FIG. 5 to FIG. 16. The support structure 20 is located between the top wall 131 and the bottom wall 132. A physical attribute of the support structure 20 is adjusted, so that deformation capabilities of the first region 12 and the second region 11 are different. The physical attribute of the support structure 20 includes a height of the support structure 20, a diameter of the support structure 20, and a density of the support structure 20.

It should be understood that the physical attribute of the support structure 20 is not limited to the foregoing enumerated attributes, and manners that can make the first region 12 and the second region 11 have different deformation capabilities fall within the protection scope of this application. This is not strictly limited.

Therefore, the housing 10 can be divided into the first region 12 and the second region 11 by adjusting a related parameter of the support structure 20, so that the second region 11 has a greater deformation capability than the first region 12 and can provide a deformation space for the coolant, and the coolant has a specific compression and relaxation space. Specifically, when the temperature of the coolant increases and the coolant expands, a cavity wall of the accommodation cavity 13 expands, and an outer surface of the second region 11 is driven to protrude, thereby effectively absorbing volume expansion of the coolant when the temperature of the coolant increases. When the temperature of the coolant decreases and the coolant shrinks, the cavity wall of the accommodation cavity 13 shrinks, and the outer surface of the second region 11 is driven to be depressed, thereby effectively adapting to volume shrinkage when the temperature of the coolant decreases.

In this arrangement, the volume change of the coolant caused by the temperature change is fully considered when the parameter of the support structure 20 is set. Possibilities of problems in the conventional technology such as a large stress generated by the liquid cooling plate 100 due to no deformation space for the coolant, or a structure is damaged because the liquid cooling plate 100 expands at a weakest position and a surrounding component at the weakest position of the structure is interfered are minimized. In this way, the overall liquid cooling plate 100 has good mechanical strength, and the work reliability of the liquid cooling plate 100 is effectively improved.

The following describes, by using three specific embodiments, how to make the deformation capabilities of the first region 12 and the second region 11 different by adjusting the physical attribute of the support structure 20.

### Embodiment 1

In Embodiment 1 of this application, deformation capabilities of a first region 12 and a second region 11 may be different by adjusting a density of support structures 20.

Refer to FIG. 8, FIG. 9, FIG. 10, and FIG. 11. The support structures 20 are disposed in the first region 12 and the second region 11. Specifically, the support structures 20 include a plurality of first support columns 21 and a plurality of second support columns 22. The plurality of first support columns 21 are connected between a top wall 131 and a bottom wall 132 and are arranged in the first region 12 at intervals. That is, each first support column 21 is supported between the top wall 131 and the bottom wall 132, and can provide strong support for mechanical strength of a liquid cooling plate 100. For example, the plurality of first support columns 21 are evenly arranged in the first region 12. A cross-sectional form of the first support column 21 may include one or a combination of a plurality of shapes such as a rectangle, a circle, and a diamond. The shape of the first support column 21 may be flexibly adjusted based on an actual situation, and this is not strictly limited.

The plurality of second support columns 22 are connected between the top wall 131 and the bottom wall 132 and are arranged in the second region 11 at intervals. That is, each second support column 22 is supported between the top wall 131 and the bottom wall 132, and can provide strong support for the mechanical strength of the liquid cooling plate 100. For example, the plurality of second support columns 22 are evenly arranged in the second region 11. A cross-sectional form of the second support column 22 may include one or a combination of a plurality of shapes such as a rectangle, a circle, and a diamond. The shape of the second support column 22 may be flexibly adjusted based on an actual situation, and this is not strictly limited.

In a possible implementation, a groove is disposed on an outer surface of the first support column 21 and/or an outer surface of the second support column 22, or a protrusion is disposed on an outer surface of the first support column 21 and/or an outer surface of the second support column 22. Therefore, a contact area between a coolant and the support columns can be increased, so that the coolant can fully contact the liquid cooling plate 100, thereby achieving good heat dissipation and cooling effect.

For example, the first support column 21 and the second support column 22 may be manufactured through etching, stamping, or the like. The first support column 21 and the second support column 22 may be disposed on a top cover plate 14 at the same time, and are connected to a bottom cover plate 15 through brazing, laser welding, or the like. Alternatively, the first support column 21 and the second support column 22 may be disposed on the bottom cover plate 15 at the same time, and are connected to the top cover plate 14 through brazing, laser welding, or the like. Alternatively, the first support column 21 may be disposed on one of the top cover plate 14 and the bottom cover plate 15, and the second support column 22 may be disposed on the other of the top cover plate 14 and the bottom cover plate 15. The first support column 21 is connected to the corresponding cover plate and the second support column 22 is connected to the corresponding cover plate through brazing, laser welding, or the like.

In this embodiment, a housing 10 can be divided into the first region 12 and the second region 11 by adjusting relative density of the first support column 21 and the second support column 22.

Specifically, a spacing between two adjacent first support columns 21 is less than a spacing between two adjacent second support columns 22. That is, a density (dense degree) of the support columns in the second region 11 is less than a density (dense degree) of the support columns in a non-expansion region. In other words, by comparing the two, the first region 12 in which the plurality of first support columns 21 are located is a high-density region in which the support columns are dense, and the second region 11 in which the plurality of second support columns 22 are located is a low-density region in which the support columns are sparsely arranged. "High" and "low" in the high-density region and the low-density region represent relative concepts between the two, and represent only relative densities of the support columns in the two regions, but not absolute densities of the support columns in the two regions. The high-density region and the low-density region are relative. That is, if there are two regions with different densities of the support columns in the housing 10, the region with a higher density is the high density region, and the region with a lower density is the low density region.

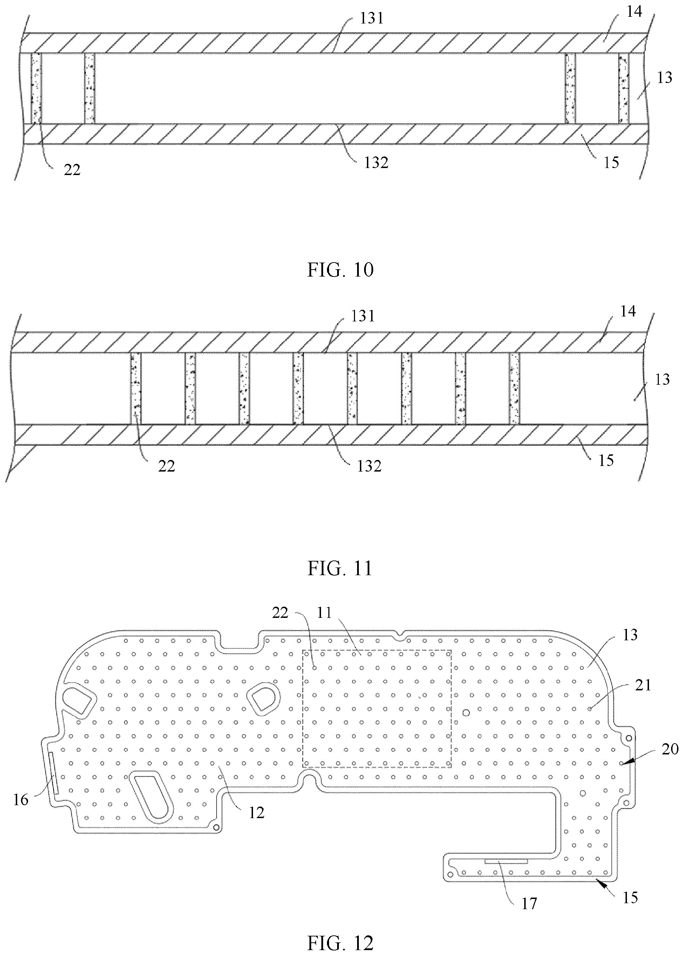

In a possible implementation, as shown in FIG. 10, the second support column 22 is disposed on only a periphery of the second region 11 and is connected between the top wall 131 and the bottom wall 132, and the second support column 22 is not disposed in a center of the second region 11.

In another possible implementation, as shown in FIG. 11, the second support column 22 is disposed in only the center of the second region 11 and is connected between the top wall 131 and the bottom wall 132, and the second support column 22 is not disposed on the periphery of the second region 11.

Therefore, the support columns in the second region 11 adopt a sparse position design by reducing a quantity of the support columns, and the second region 11 can be made into a deformable region with soft strength, thereby effectively reducing the local bending stiffness of the second region 11, so that the second region 11 has a greater deformation capability than the first region 12, and absorbs volume and pressure changes of the liquid coolant in the accommodation cavity 13 through moderate deformation. In addition, the support columns in the first region 12 adopt a dense position design, so that the first region 12 can be made into a hard and less deformable region, thereby effectively improving the local bending stiffness of the first region 12, so that the first region 12 has a smaller deformation capability than the second region 11, and provides better mechanical strength for the overall liquid cooling plate 100 and ensure the reliability of the liquid cooling plate 100 during operation.

For example, the spacing between two adjacent first support columns 21 may be 8.0 mm (millimeter), the spacing between two adjacent second support columns 22 may be 4.0 mm (millimeter), and a ratio of the spacing between two adjacent first support columns 21 to the spacing between two adjacent second support columns 22 is 2:1.

It should be noted that the ratio of the spacing between two adjacent first support columns 21 to the spacing between two adjacent second support columns 22 may be flexibly adjusted based on an actual situation, so that the housing 10 can be divided into the first region 12 and the second region 11. This is not strictly limited in this embodiment.

### Embodiment 2

In Embodiment 2 of this application, what is different from Embodiment 1 is that deformation capabilities of a first region 12 and a second region 11 may be different by adjusting a height of a support structure 20. The height of the support structure 20 is a dimension in a direction perpendicular to a top cover plate 14, in other words, a distance from one end of the support structure 20 to the other end.

Refer to FIG. 12 to FIG. 16. The support structures 20 are disposed in the first region 12 and the second region 11. Specifically, the support structures 20 include a plurality of first support columns 21 and a plurality of second support columns 22. In FIG. 12, an inner part of a dotted box is the second region 11, and a part outside of the dotted box is the first region 12.

The plurality of first support columns 21 are connected between a top wall 131 and a bottom wall 132 and are arranged in the first region 12 at intervals. That is, each first support column 21 is supported between the top wall 131 and the bottom wall 132, and can provide strong support for mechanical strength of a liquid cooling plate 100. For example, the plurality of first support columns 21 are evenly arranged in the first region 12. A cross-sectional form of the first support column 21 may include one or a combination of a plurality of shapes such as a rectangle, a circle, and a diamond. The shape of the first support column 21 may be flexibly adjusted based on an actual situation, and this is not strictly limited.

One end of one or more of the plurality of second support columns 22 is connected to the top wall 131, the other end is spaced apart from the bottom wall 132, and the plurality of second support columns 22 are arranged in the second region 11 at intervals. For example, the plurality of second support columns 22 are evenly arranged in the second region 11. A cross-sectional form of the second support column 22 may include one or a combination of a plurality of shapes such as a rectangle, a circle, and a diamond. The shape of the second support column 22 may be flexibly adjusted based on an actual situation, and this is not strictly limited.

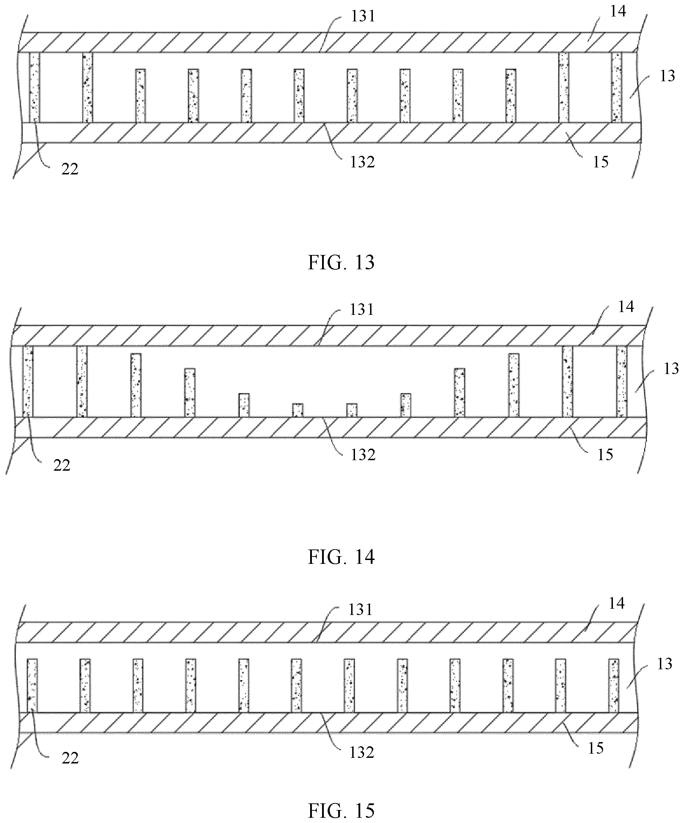

In a possible implementation, as shown in FIG. 13, second support columns 22 located on outer peripheries are connected between the top wall 131 and the bottom wall 132. One end of second support columns 22 located in a center is connected to the bottom wall 132, the other end is spaced apart from the bottom wall 132, and heights of the second support columns 22 in the center are the same.

That is, heights of the second support columns 22 located on outer peripheries are greater than the heights of the second support columns 22 located in the center, and the heights of the second support columns 22 located in the center are the same. The height refers to a length from one end that is of the support column and that is connected to a bottom cover plate 15 to the other end that is away from the bottom cover plate 15, in other words, a size of the support column in a direction perpendicular to a housing 10. In other words, among all the second support columns 22, heights of second support columns 22 whose heights are not adapted to a distance between the top cover plate 14 and the bottom cover plate 15 may be the same.

In another possible implementation, as shown in FIG. 14, second support columns 22 located on outer peripheries are connected between the top wall 131 and the bottom wall 132. One end of second support columns 22 located in the center is connected to the bottom wall 132, the other end is spaced apart from the bottom wall 132, and heights of the second support columns 22 located in the center are different.

That is, heights of the second support columns 22 located on outer peripheries are greater than the heights of the second support columns 22 located in the center, and the heights of the second support columns 22 located in the center are different. The height refers to a length from one end that is of the support column and that is connected to the bottom cover plate 15 to the other end that is away from the bottom cover plate 15, in other words, a size of the support column in a direction perpendicular to a housing 10. In other words, among all the second support columns 22, the heights of the second support columns 22 whose heights are not adapted to the distance between the top cover plate 14 and the bottom cover plate 15 may be different. For example, the heights of the second support columns 22 in the center may be arranged in a gradient manner, or the heights of the second support columns 22 in the center may be arranged symmetrically about the center.

In still another possible implementation, as shown in FIG. 15, one end of the second support columns 22 located in the second region 11 is connected to the bottom cover plate 15, the other end is spaced apart from the top cover plate 14, and heights of all the second support columns 22 are the same. The height refers to a length from one end that is of the support column and that is connected to the bottom cover plate 15 to the other end that is away from the bottom cover plate 15, in other words, a size of the support column in a direction perpendicular to the housing 10.

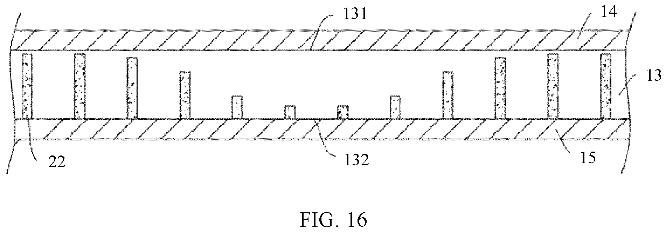

In yet another possible implementation, as shown in FIG. 16, one end of the second support columns 22 located in the second region 11 is connected to the bottom cover plate 15, the other end is spaced apart from the top cover plate 14, and heights of the second support columns 22 are different. The height refers to a length from one end that is of the support column and that is connected to the bottom cover plate 15 to the other end that is away from the bottom cover plate 15, in other words, a size of the support column in a direction perpendicular to the housing 10.

It should be noted that heights and positions of the second support columns 22 are not limited to the cases described above, and the positions and the heights of the second support columns 22 may be flexibly set based on an expansion situation that the second region 11 actually needs to meet, provided that the second region 11 can absorb thermal expansion and contraction of the coolant. This is not strictly limited in this embodiment.

For example, the first support column 21 and the second support column 22 may be manufactured through etching, stamping, or the like. The first support column 21 and the second support column 22 may be disposed on the top cover plate 14 at the same time, and are connected to the bottom cover plate 15 through brazing, laser welding, or the like. Alternatively, the first support column 21 and the second support column 22 may be disposed on the bottom cover plate 15 at the same time, and are connected to the top cover plate 14 through brazing, laser welding, or the like. Alternatively, the first support column 21 may be disposed on one of the top cover plate 14 and the bottom cover plate 15, and the second support column 22 may be disposed on the other of the top cover plate 14 and the bottom cover plate 15. The first support column 21 is connected to the corresponding cover plate and the second support column 22 is connected to the corresponding cover plate through brazing, laser welding, or the like. In addition, in this embodiment, a spacing between two adjacent first support columns 21 may be equal to a spacing between two adjacent second support columns 22. That is, a density (dense degree) of the second support columns 22 in the second region 11 is the same as a density (dense degree) of the first support columns 21 in the first region 12.

In this embodiment, the housing 10 can be divided into the first region 12 and the second region 11 by adjusting heights of the first support columns 21 and the second support columns 22.

Specifically, in the first region 12, heights of the plurality of first support columns 21 are adapted to a vertical distance between the top wall 131 and the bottom wall 132. However, in the second region 11, heights of one or more of the plurality of second support columns 22 may not be adapted to the vertical distance between the top wall 131 and the bottom wall 132.

Therefore, one end of the support columns in the second region 11 may not form a connection and support relationship with the corresponding cover plate by reducing heights of the support columns, and the second region 11 can be made into a deformable region with soft strength, thereby effectively reducing local bending stiffness of the second region 11, so that the second region 11 has a greater deformation capability than the first region 12, and absorbs volume and pressure changes of the liquid coolant in an accommodation cavity 13 through moderate deformation. In addition, the support columns in the first region 12 are supported between the top wall 131 and the bottom wall 132, so that the first region 12 can be made into a hard and less deformable region, thereby effectively improving the local bending stiffness of the first region 12, so that the first region 12 has a smaller deformation capability than the second region 11, and can provide better mechanical strength for the overall liquid cooling plate 100 and ensure the reliability of the liquid cooling plate 100 during operation.

For example, a height of each first support column 21 may be 0.6 mm (millimeter), and a height of each second support column 22 may be 0.25 mm (millimeter).

### Embodiment 3

In Embodiment 3 of this application, what is different from Embodiment 1 is that deformation capabilities of a first region 12 and a second region 11 may be different by adjusting positions of support structures 20.

Refer to FIG. 5, FIG. 6, and FIG. 7. The support structures 20 are disposed in only the first region 12. Specifically, there are a plurality of support structures 20, and the plurality of support structures 20 are connected between a top wall 131 and a bottom wall 132, and are arranged in the first region 12 at intervals. That is, each support structure 20 is supported between the top wall 131 and the bottom wall 132, and can provide strong support for mechanical strength of a liquid cooling plate 100. For example, the plurality of support structures 20 are evenly arranged in the first region 12. A cross-sectional form of the support structure 20 may include one or a combination of a plurality of shapes such as a rectangle, a circle, and a diamond. The shape of the support structure 20 may be flexibly adjusted based on an actual situation, and this is not strictly limited.

For example, the support structure 20 may be made through etching, stamping, or the like. All the support structures 20 may be disposed on a top cover plate 14 and connected to a bottom cover plate 15 through brazing, laser welding, or the like. Alternatively, all the support structures 20 may alternatively be disposed on the bottom cover plate 15 and connected to the top cover plate 14 through brazing, laser welding, or the like.

In this embodiment, a housing 10 can be divided into the first region 12 and the second region 11 by adjusting the positions of the plurality of support structures 20. Specifically, the plurality of support structures 20 are disposed in only the first region 12, and no support structures 20 is disposed in the second region 11.

Therefore, the second region 11 may be made into a deformable region with soft strength without providing the support structure 20, thereby effectively reducing local bending stiffness of the second region 11, so that the second region 11 has a greater deformation capability than the first region 12, and absorbs volume and pressure changes of a liquid coolant in an accommodation cavity 13 through moderate deformation. In addition, the support columns in the first region 12 are supported between the top wall 131 and the bottom wall 132, so that the first region 12 can be made into a hard and less deformable region, thereby effectively improving the local bending stiffness of the first region 12, so that the first region 12 has a smaller deformation capability than the second region 11, and can provide better mechanical strength for the overall liquid cooling plate 100 and ensure the reliability of the liquid cooling plate 100 during operation.

Based on the foregoing description, it should be understood that, according to the electronic device 300 in which the liquid cooling plate 100 is used in this embodiment of this application, a natural heat dissipation area of the electronic device 300 can be expanded to a screen side, thereby implementing a breakthrough in natural heat dissipation of the electronic device 300, and greatly improving the working performance of the electronic device 300. In addition, because the liquid cooling plate 100 has a function of absorbing thermal expansion and contraction, a storage temperature of a system matching the liquid cooling plate 100 can be greatly reduced, and reliability is good.

Embodiments of this application are described in detail above. A principle and implementations of this application are described herein through specific examples. The description about embodiments of this application is merely provided to help understand the method and core ideas of this application. In addition, persons of ordinary skill in the art can make variations and modifications to this application in terms of the specific implementations and application scopes according to the ideas of this application. Therefore, the content of specification shall not be construed as a limit to this application.

## Claims

1. A liquid cooling plate, wherein the liquid cooling plate comprises:
a housing, wherein the housing comprises a top wall and a bottom wall, the top wall and the bottom wall are covered to form an accommodation cavity, and the accommodation cavity comprises a first region and a second region;
a support structure, wherein the support structure is disposed in the first region and connected between the top wall and the bottom wall; and
a coolant, wherein the coolant flows in the accommodation cavity to dissipate heat from a heat generating device, the coolant can expand in volume when being heated and shrink in volume when being cooled, and the second region can deform to absorb a volume variation of the coolant.

2. The liquid cooling plate according to claim 1, wherein the first region is used to contact the heat generating device.

3. The liquid cooling plate according to claim 1 or 2, wherein the second region and the heat generating device are disposed in a staggered manner.

4. The liquid cooling plate according to any one of claims 1 to 3, wherein the support structure comprises a plurality of first support columns, the plurality of first support columns are arranged in the first region at intervals, and the plurality of first support columns are all connected between the top wall and the bottom wall.

5. The liquid cooling plate according to any one of claims 1 to 3, wherein the support structure is further disposed in the second region.

6. The liquid cooling plate according to claim 5, wherein the support structure comprises a plurality of first support columns and a plurality of second support columns, the plurality of first support columns are arranged in the first region at intervals, and the plurality of second support columns are arranged in the second region at intervals; and
the plurality of first support columns and the plurality of second support columns are all connected between the top wall and the bottom wall, and a spacing between two adjacent first support columns is less than a spacing between two adjacent second support columns.

7. The liquid cooling plate according to claim 5, wherein the support structure comprises a plurality of first support columns and a plurality of second support columns, the plurality of first support columns are arranged in the first region at intervals, and the plurality of second support columns are arranged in the second region at intervals; and
the plurality of first support columns are all connected between the top wall and the bottom wall, one end of one or more of the plurality of second support columns is connected to the bottom wall, and the other end is spaced apart from the top wall.

8. The liquid cooling plate according to claim 7, wherein heights of the plurality of second support columns whose other ends are spaced apart from the top wall are the same, and the height is a size of the second support column in a direction perpendicular to the housing; or
heights of the plurality of second support columns whose other ends are spaced apart from the top wall are different, and the height is a size of the second support column in a direction perpendicular to the housing.

9. The liquid cooling plate according to any one of claims 6 to 8, wherein a groove is disposed on an outer surface of the first support column and/or an outer surface of the second support column, or a protrusion is disposed on an outer surface of the first support column and/or an outer surface of the second support column.

10. The liquid cooling plate according to any one of claims 1 to 9, wherein a bending stiffness of the second region is less than a bending stiffness of the first region.

11. Aliquid cooling system, wherein the liquid cooling system comprises a delivery apparatus and the liquid cooling plate according to any one of claims 1 to 10, and the delivery apparatus is connected to the liquid cooling plate, and is configured to drive a coolant to flow in the liquid cooling plate.

12. An electronic device, wherein the electronic device comprises a housing and the liquid cooling system according to claim 11, and the liquid cooling system is located inside the housing.
